# EUROPÄISCHE PATENTSCHRIFT

(11) **EP 2 051 327 B1**
(45) Veröffentlichungstag und Bekanntmachung des Hinweises auf die Patenterteilung: **09.06.2010**
(21) Anmeldenummer: 08450155.0
(22) Anmeldetag: 09.10.2008
(51) Int. Cl.: H01Q 5/00, H01Q 9/28, H01Q 11/04, H01Q 23/00, G01R 29/08, G01R 35/00

(54) **Antenne mit Kammgenerator**
Antenna with comb generator
Antenne dotée d'un générateur de peigne

(30) Priorität: 19.10.2007 AT 16902007
(43) Veröffentlichungstag der Anmeldung: 22.04.2009
(73) Patentinhaber: Seibersdorf Labor GmbH, 2444 Seibersdorf (AT)
(72) Erfinder: Müllner, Wolfgang Dipl.-Ing., 2486 Landegg (AT); Kriz, Alexander Dipl.-Ing., 2434 Götzendorf (AT); Haider, Harald Dipl.-Ing., 1110 Wien (AT)
(74) Vertreter: Wildhack & Jellinek

(56) Entgegenhaltungen:
- DE-A1-102006 004 806
- GARN H F ET AL: "Problems with radiated-emission testing at 3 m distance according to CISPR 11 and CISPR 22" ELECTROMAGNETIC COMPATIBILITY, 1993. SYMPOSIUM RECORD., 1993 IEEE INTE RNATIONAL SYMPOSIUM ON DALLAS, TX, USA 9-13 AUG. 1993, NEW YORK, NY, USA,IEEE, 9. August 1993 (1993-08-09), Seiten 216-221, XP010149634 ISBN: 978-0-7803-1304-0
- ANONYMOUS: "The essential tool for EMC & EMF test lab Quality Assurance RefR ad X - Comb Gener ator and Field Source" ARC PRODUCTS INFOSHEET, [Online] XP002510919 Gefunden im Internet: URL:http://www.seibersdorf-rf.com/docs/lea flet/W_Products_RefRad_X_engl.pdf> [gefunden am 2009-01-19]

## Beschreibung

Die Erfindung betrifft eine Antenne gemäß dem Oberbegriff des Anspruches 1.

Die Erfindung wird im Bereich der Kalibrierung von Messanlagen zur Bestimmung der elektromagnetischen Verträglichkeit von elektrischen Geräten und Bauelementen verwendet.

Ein wesentliches Problem des Standes der Technik besteht darin, dass für Kalibrierungseinrichtungen für Messeinrichtungen zur Bestimmung der elektromagnetischen Abstrahlung von Geräten oder Bauelementen die Reproduzierbarkeit der abgestrahlten Feldstärke gering ist, weil ein feldbeeinflussendes Zuleitungskabel zum Einstellen der entsprechenden Abstrahlungsfrequenz einer Kalibrierungsantenne verwendet wird. Ein wesentlicher Nachteil ist hierbei, dass die abgestrahlten elektromagnetischen Wellen von weiteren elektromagnetischen Wellen überlagert werden, welche von dem an einen Kammgenerator angeschlossenen Zuleitungskabel ausgehen. Weiters kann dieses Zuleitungskabel, insbesondere im Nahebereich der Antenne, zu wesentlichen Feldverzerrungen aufgrund seiner metallischen Eigenschaften führen. Der Kammgenerator, welcher sich außerhalb der Antenne befindet sowie die Zuleitungskabel verzerren durch die Abstrahlung von elektromagnetischen Störwellen das Nutzfeld.

Ziel der Erfindung ist es, die eingangs erwähnten Probleme zu lösen und eine Antennenkonstruktion zur Verfügung zu stellen, welches die eingangs genannten Probleme überwindet.

Die Erfindung löst die Aufgabe mit einer Antenne mit den Merkmalen des Kennzeichens des Anspruches 1.

Ein wesentlicher Vorteil der erfindungsgemäßen Antenne besteht darin, dass kein externes, metallisches Zuleitungskabel benötigt wird und somit Feldverzerrungen weitestgehend vermieden werden. Es handelt sich hierbei um eine hochsymmetrischen Aufbau, wobei das elektromagnetische Feld auch im Nahebereich der Antenne präzise und einfach vorhersagbar ist.

Zur verzerrungsfreien Abstrahlung elektromagnetischer Wellen von längerer Wellenlänge sind Antennen gemäß den Ansprüchen 2 und 3 von Vorteil.

Eine Antenne gemäß den Ansprüchen 4 oder 5 bietet ein vorhersagbares und hochpräzises magnetisches Feld.

Eine Antenne gemäß Anspruch 6 bietet den Vorteil, elektromagnetische Wellen mit größerer Wellenlänge abzustrahlen und das Gewicht der Antenne zu reduzieren. Eine Antenne gemäß einem der Ansprüche 7 bis 9 erhöht die Präzision des abgestrahlten elektromagnetischen Feldes.

Gemäß den Ansprüchen 10 und 11 kann der in der Antenne befindliche Kammgenerator bei gleichbleibender Feldqualität extern synchronisiert werden.

Eine Antenne gemäß dem Anspruch 12 weist eine besonders einfache Kabelführung auf.

Eine Anordnung gemäß Anspruch 13 kann zur Kalibrierung von Messanlagen verwendet werden.

Eine Anordnung gemäß Anspruch 14 hat den Vorteil, dass die Konfiguration besonders präzise durchgeführt werden kann, da die entsprechenden Empfangskomponenten ortsfest angeordnet sind.

Eine Anordnung gemäß Anspruch 15 bietet die Möglichkeit, einer hohen Messdynamik bzw. eines großen Signal-Rauschabstandes.
Fig. 1 zeigt die Anordnung des Kammgenerators und der Batterien in der Antenne.
Fig. 2 zeigt die Geometrie der erfindungsgemäßen Hohlkegelantenne.
Fig. 3 zeigt eine Antenne aus konisch geformten Drahtgittern.
Fig. 4 zeigt ein Anordnung mit einer Antenne, einer Empfangsantenne und einem Messempfänger.
Fig. 5 zeigt eine Anordnung mit Antenne und Empfangsantenne in einem Raum.

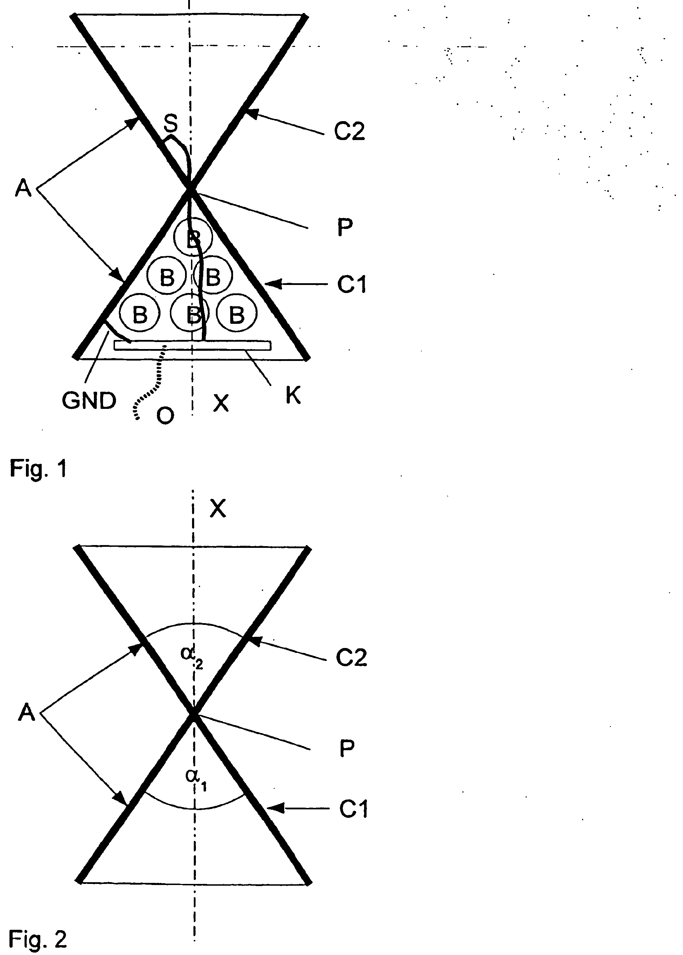

Fig. 2 zeigt eine Antenne A mit Kammgenerator K zum Emittieren von verzerrungsarmen elektromagnetischen Messfeldern im MHz- bis GHz-Bereich. Die Antenne A umfasst zwei Hohlkegel C₁, C₂ mit einer gemeinsamen Symmetrieachse X und einem gemeinsamen Scheitelpunkt P, wobei die Öffnungen der beiden Hohlkegel C₁, C₂ in entgegengesetzte Richtungen weisen. Die Öffnungswinkel α₁, α₂ der beiden Hohlkegel C₁, C₂ sind gleich groß. Jeder Hohlkegel C₁, C₂ ist aus Metall und/oder aus einem Drahtgitter gebildet. Die Hohlkegel sind gegeneinander isoliert. Im Bereich des Scheitelpunkts P weicht die Form der Hohlkegel C1, C2 konstruktionsbedingt von einer reinen Kegelform ab und ist, insbesondere zylindrisch oder hyperbolisch. Zur Durchführung des Kabels ist eine parallel zur Achse X verlaufende Ausnehmung in dem die Kegel verbindenden Bereich vorgesehen.

Fig. 1 zeigt die Antenne mit eingebautem Kammgenerator K und Stromversorgung.

Im Innenraum eines der beiden Hohlkegel C₁, C₂ ist ein Kammgenerator K angeordnet, welcher mit beiden Hohlkegeln C₁, C₂ elektrisch verbunden ist bzw. an die beiden Hohlkegel C₁, C₂ angeschlossen ist. Die Signalmasse GND wird dabei an einen der beiden Kegel angelegt, während das Signal S an den jeweils anderen der Hohlkegel C1, C2 angeschlossen ist. Die Beschaltung des Hohlkegels, welcher dem den Kammgenerator K aufnehmenden Hohlkegel gegenüberliegt, erfolgt im Bereich des Scheitelpunktes P durch eine, vorzugsweise zylindrische Durchführung, durch den zylindrisch oder hyperbolisch geformten Bereich des Zusammentreffens der beiden Kegel. Die Zuleitungen für die Signalmasse und das Antennensignal können hierbei abgeschirmt sein, um eventuelle Feldverzerrungen zu vermeiden.

Ist der Hohlkegel, welcher den Kammgenerator K aufnimmt, teilweise aus Drahtgitter gebildet, so können zusätzlich Abschirmmaßnahmen um den Kammgenerator K angeordnet sein.

Zur Stromversorgung des Kammgenerators K werden Batterien B in jenem Hohlkegel C₁ oder C₂ angeordnet, in welchem sich auch der Kammgenerator K befindet. Ist dies aus Platzgründen nicht möglich oder ist eine längere Betriebsdauer erforderlich, können Batterien B selbstverständlich auch in dem, dem Kammgenerator K gegenüberliegenden Hohlkegel angeordnet sein. In diesem Fall ist jedoch eine koaxiale Durchführung der Stromversorgung zwischen den Hohlkegeln C1, C2 vorzusehen. Im Bereich des Scheitelpunktes P, in welchem die Form der Hohlkegel C1, C2 konstruktionsbedingt von einer reinen Kegelform abweicht, kann neben der Durchführung des kammförmigen Antennensignals durch eine, insbesondere parallel zur Achse X geführte, die Innenseiten der beiden Hohlkegel C1, C2 verbindende Ausnehmung auch eine weitere Durchführung für eine Stromversorgung vorgesehen werden.

Die Batterien B sind im Nahebereich des Scheitelpunkts P im Inneren desjenigen Hohlkegels C1, C2 angeordnet sind, welcher den Kammgenerator K umschließt. Vorteilhafteiweise ist der Kammgenerator auf einer Platine angeordnet. Diese Platine ist an der Seite der Batterien B angeordnet, welche dem Scheitelpunkt P fern ist. Diese Platine ist vorzugsweise eben ausgestaltet, kann jedoch auch an die Form der Batterien B und des Kegels angepasst werden.

Die Wände der Hohlkegel C1, C2 sind entweder aus Metall oder aus einem Drahtgitter oder Drahtgeflecht gebildet. Falls die Wände aus einem Drahtgeflecht oder einem Drahtgitter gebildet sind, ist der Kammgenerator K sowie gegebenenfalls vom Kammgenerator K wegführende Kabel, mit zusätzlichen Schirmungsmaßnahmen versehen sind.

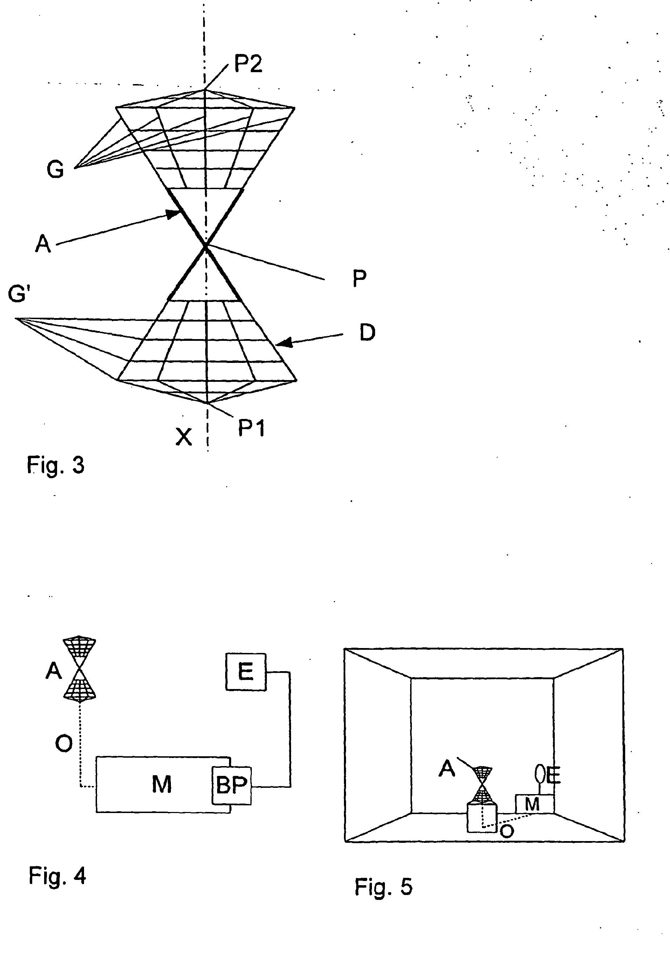

Fig. 3 zeigt eine Antenne A mit einem eingebauten Kammgenerator K, wobei die beiden Hohlkegel C1, C2 an ihrem, dem Scheitelpunkt P fernen Ende, jeweils mit einem konisch geformten Drahtgitter G versehen sind. Jedes dieser Drahtgitter D umfasst mehrere Gitterstäbe G, welche bezüglich des Scheitelpunktes P radial nach außen gerichtet verlaufen. Sie sind mit einem der beiden Hohlkegel C1 oder C2 verbunden und enden im gleichen Abstand vom Scheitelpunkt P. Ferner können weitere kreisförmige oder elliptische Drahtgitterstäbe G' an den radial verlaufenden Drahtgitterstäben angebracht sein, welche entlang der Wand der Hohlkegel C1, C2 verlaufen. Einzelne radial verlaufende Gitterstäbe G sind an ihren den Scheitelpunkt P fernen Ende vorzugsweise mit einem umlaufenden Drahtgitterstab G' verbunden.

Auf der Symmetrieachse X liegen zwei weitere Scheitelpunkte P1, P2 außerhalb des geometrischen Körpers der durch die Drahtgitterstäbe G, G' aufgespannten Kegel auf gegenüberliegenden Seiten des Scheitelpunkts P. An den dem Scheitelpunkt P fernen Enden der einzelnen Drahtgitterstäbe G eines Hohlkegels ist jeweils ein weiteres konisch geformtes Drahtgitter E angeschlossen, welches zu einem weiteren Scheitelpunkt P1, P2 zusammenläuft. In diesen Scheitelpunkten P1, P2 sind weitere Drahtgitterstäbe H, kegelförmig zusammengeführt, wobei die Grundflächen der von den Drahtgitterstäben aufgespannten Hohlkegel mit den Grundflächen der jeweiligen durch die Drahtgitterstäbe G aufgespannten Hohlkegel gleich sind. Entsprechend können auch weitere kreisförmige oder elliptische Drahtgitterstäbe H' an den radial in den Punkten P1 und P2 zusammengeführten Drahtgitterstäben H angebracht sein.

Zur Synchronisation des Kammgenerators K mit einem externen Signalgeber ist, wie in Fig. 1 gezeigt, am Kammgenerator K ein optischer Synchronisationseingang vorgesehen. Ein optisches Kabel O erweist sich für die Synchronisation des Kammgenerators mit einem externen Synchronisationssignal deswegen als vorteilhaft, weil die Beeinflussung des elektromagnetischen Feldes im Nahebereich der Antenne A im Gegensatz zu einem elektrisch leitenden metallischen Kabel äußerst gering ist. Die Reflexion und Absorption von elektromagnetischen Wellen an optischen Kabeln ist für den Anwendungsfall vernachlässigbar. Im Nahebereich der Antenne A, in welchem Beeinträchtigungen der Geometrie die größten Feldverzerrungen bewirken, kann somit ein optisches Kabel O zur Synchronisation des Kammgenerators K mit einem externen Signal verwendet werden. Dieses optische Kabel ist entweder durch eine Öffnung im Hohlkegel C₁ oder C₂ geführt oder durch die Grundfläche des den Kammgenerator umfassenden Hohlkegels C₁ oder C₂ aus diesem herausgeführt.

Vorteilhafterweise kann vorgesehen werden, dass dem Synchronisationseingang eine Schaltung zur Erkennung eines Synchronisationssignals des Kammgenerators K nachgeschaltet ist. Wird ein Synchronisationssignal erkannt, wird dieses zum Kammgenerator K geleitet, andernfalls wird ein interner Oszillator im Kammgenerator aktiviert, welcher ein entsprechendes Frequenzsignal erzeugt.

Um eine Messanlage zur Vermessung einzelner elektrisch aktiver Gegenstände zu kalibrieren, wird eine Anordnung mit einer Antenne A umfassend einen Kammgenerator K sowie eine Empfangsantenne E und einem Messempfänger M verwendet. Für die Kalibrierung wird die Antenne A an jene Position gebracht, in welcher sich während des Normalbetriebs das zu vermessende elektrische Gerät befindet. Die übrige Messanordnung ist für Kalibrierung und Normalbetrieb dieselbe. Der Messempfänger M ist sowohl an die Empfangsantenne E als auch an den Kammgenerator K angeschlossen, wobei im Nahbereich der Antenne A ein optisches Kabel O zur Synchronisation mit einem externen, vorzugsweise im Messempfänger generierten, Signal verwendet wird. Aufgrund der während der Kalibrierung und des Normalbetriebes identischen Anordnung der Empfangsantenne E in der Messanordnung ist eine entsprechende optische Verbindung der Empfangsantenne E mit dem Messempfänger M nicht zwingend erforderlich. Die Empfangsantenne E ist mit der Antenne A bzw. dem in Antenne A befindlichen Kammgenerator K über den Messempfänger M synchronisiert. Der Empfangsantenne E ist ein Bandpassfilter BP nachgeschaltet, welcher auf ein Vielfaches der Synchronisationsfrequenz f₀ eingestellt ist. Der Bandpass BP ist in der vorliegenden Ausgestaltung im Messempfänger M angeordnet. Die Synchronisationsfrequenz f₀ wird über das optische Kabel O auch an den Kammgenerator K geleitet und ersetzt dort den eingebauten Takt des Kammgenerators.

Die Detektion und Emission von elektromagnetischen Messfeldern wird vorzugsweise in einem (Hochfrequenz - echoarmen) Raum durchgeführt, in welchem die Empfangsantenne E und die Antenne A angeordnet sind. Entsprechende Verkabelung sowie der Messempfänger M können sich außerhalb des Raums befinden. Kabelführungen, insbesondere zur Antenne E sind möglichst abgeschirmt geführt. Das Synchronisationskabel zur Antenne A ist speziell im Nahbereich der Antenne A optisch ausgeführt.

Ziel einer solchen Anordnung ist es, einen möglichst hohen Signal-Rausch-Abstand von etwa 120 dB zu erreichen und das entsprechende Messverfahren für Frequenzen im MHz- bzw. GHz-Bereich durchzuführen. Der Kammgenerator K sowie der Messempfänger M sind hierbei synchronisiert. Die Grundfrequenz f₀ des internen Messempfängertaktsignals wird, gegebenenfalls mittels eines optoelektronischen Kopplers in ein optisches Signal transformiert, und über das optische Kabel O in den Kammgenerator K geleitet. Ein Referenzeingang ist am Kammgenerator angeordnet, ein entsprechender Referenzfrequenzausgang ist am Messempfänger M angeordnet.

Das Vorhandensein des optischen Synchronisationssignals wird automatisch erkannt und die interne Takterzeugung des Kammgenerators (K) wird bei externer Synchronisation automatisch abgeschaltet.

Im Kammgenerator K wird ein kammförmiges Antennensignal erzeugt und an die beiden Hohlkegel C1, C2 der Antenne A weitergeleitet. Von der Antenne A werden elektromagnetische Wellen durch das Kammsignal angeregt und entsprechend abgestrahlt und von der Empfangsantenne E empfangen. Der schmalbandige Bandpassfilter BP des Messempfängers wird auf ein Vielfaches n der Grundfrequenz f₀ eingestellt. Der Ausgang des Bandpassfilters BP ist an den Messverstärker M angeschlossen, wobei im wesentlichen nur die voreingestellte Oberschwingung n des Signals zum Messverstärker M gelangt, während die übrigen Signalanteile oder Schwingungsanteile im Bandpassfilter BP ausgefiltert oder gedämpft werden. Die Signalstärke des empfangenen Signals wird gemessen und gegebenenfalls digitalisiert.

Eine vorgegebene Anzahl von Vielfachen der Grundfrequenz f0 des Kammgenerators K kann analog ermittelt werden. Es werden hierbei Feldstärkemessungen im Empfangsbereich des Empfängers E vorgenommen und über den auf die entsprechende Frequenz eingestellten Bandpassfilter BP durchgeleitet. Das im Messempfänger M empfangene und gefilterte Signal wird für eine vorgegebene Anzahl von Vielfachen der Grundfrequenz f₀ bestimmt. Um einen Überblick über das elektromagnetische Strahlungsverhalten eines Messgegenstandes zu erhalten, wird ein Frequenzspektrum erstellt, wobei die Feldstärke der elektromagnetischen Wellen als für die jeweiligen Frequenzen ermittelt wird. Das Ergebnis kann gegebenenfalls als Frequenzdiagramm dargestellt werden, welches die entsprechende Messanordnung charakterisiert. Selbstverständlich können auch Phasenverschiebungen und Signallaufzeiten vermessen und einzelnen Frequenzen zugeordnet werden.

Die Antenne A wird nach Beendigung der Kalibrierung durch ein zu vermessendes elektrisches Gerät oder einen elektrischen Bauteil ersetzt und die Abstrahlung des Objekts und der Antenne A für einzelne Frequenzbereiche verglichen.

Zur Erhöhung der Messdynamik werden die Frequenz des Bandpasses BP an die Grundfrequenz bzw. ein vorgegebenes Vielfaches dieser Grundfrequenz angepasst. Die Bandbreite des Bandpassfilters liegt in einem Bereich von etwa 1 Hz bis 10 Hz.

In Fig. 5 wird ein Raum dargestellt, in welchem eine Anordnung mit Antenne und Empfangsantenne angeordnet ist. Der Raum ist mit absorbierenden Wänden bzw. mit absorbierender Decke ausgestattet. Der Boden weist entweder metallische oder absorbierende Eigenschaften auf. Die Antenne A und die Empfangsantenne E werden an vorgegebenen Stellen im Raum angeordnet.

## Patentansprüche

1. Antenne mit angeschlossenem Kammgenerator zum Emittieren von verzerrungsarmen elektromagnetischen Messfeldern im MHz bis GHz-Bereich, wobei die Antenne (A) zwei Hohlkegel (C1, C2) mit einer gemeinsamen Symmetrieachse (X) und einen gemeinsamen Scheitelpunkt (P) umfasst, deren Öffnungen in entgegengesetzte Richtungen weisen, wobei die beiden Hohlkegel (C1. C2) insbesondere mit Metall oder mit Drahtgitter geformt sind, **dadurch gekennzeichnet,**
- **dass** der Kammgenerator (K) im Innenraum eines der beiden die Antenne (A) bildenden Hohlkegel (C1, C2) angeordnet ist, und
- **dass** Batterien (B) zur Stromversorgung des Kammgenerators (K) im Innenraum des den Kammgenerator (K) aufnehmenden Hohlkegels (C1, C2) angeordnet sind.

2. Antenne mit Kammgenerator gemäß Anspruch 1, **dadurch gekennzeichnet,**
- **dass** die Wände der Hohlkegel (C1, C2) aus Metall gebildet sind.

3. Antenne mit Kammgenerator gemäß Anspruch 1, **dadurch gekennzeichnet,**
- **dass** die Wände der Hohlkegel (C1, C2) aus einem Drahtgeflecht oder einem Drahtgitter gebildet sind und der Kammgenerator (K) sowie, gegebenenfalls vom Kammgenerator (K) wegführende Kabel, mit zusätzlichen Schirmungsmaßnahmen versehen sind.

4. Antenne mit Kammgenerator gemäß einem der vorangehenden Ansprüche, **dadurch gekennzeichnet,**
- **dass** der Kammgenerator (K) auf einer, vorzugsweise ebenen, Platine angeordnet ist.

5. Antenne mit Kammgenerator gemäß Anspruch 4, **dadurch gekennzeichnet,**
- **dass** die Batterien (B) im Nahebereich des Scheitelpunkts (P) im Inneren desjenigen Hohlkegels (C1, C2) angeordnet sind, welcher den Kammgenerator (K) umschließt, und
- **dass** die Platine, an welcher der Kammgenerator (K) angeordnet ist, an der dem Scheitelpunkt (P) fernen Seite der Batterien (B) angeordnet ist.

6. Antenne mit Kammgenerator gemäß einem der vorangehenden Ansprüche,
**dadurch gekennzeichnet,**
- **dass** jeder der Hohlkegel (C1, C2) an seinem dem Scheitelpunkt (P) fernen Ende, mit einem mit mehreren Drahtgitterstäben (G) gebildeten und konisch geformten Drahtgitter (D) verlängert ist.

7. Antenne mit Kammgenerator gemäß Anspruch 6, **dadurch gekennzeichnet,**
- **dass** an den dem Scheitelpunkt (P) fernen Enden der einzelnen Drahtgitterstäbe (G) eines Hohlkegels (C1, C2) jeweils ein weiteres konisch geformtes Drahtgitter angeschlossen ist, welches zu einem weiteren Scheitelpunkt (P1, P2) zusammenläuft.

8. Antenne mit Kammgenerator gemäß Anspruch 7, **dadurch gekennzeichnet, dass** die Scheitelpunkte (P1, P2) auf der Symmetrieachse (X), insbesondere in gleichem Abstand vom Scheitelpunkt (P), liegen.

9. Antenne mit Kammgenerator gemäß dem Anspruch 7 oder 8, **dadurch gekennzeichnet, dass** die beiden Scheitelpunkten (P1, P2) und die Enden der Drahtgitter (D) denselben Abstand vom gemeinsamen Scheitelpunkt (P) aufweisen.

10. Antenne mit Kammgenerator gemäß einem der vorangehenden Ansprüche,
**dadurch gekennzeichnet,**
- **dass** der Kammgenerator (K) einen Synchronisationseingang, insbesondere einen Anschluss für ein Kabel zur Führung von optischen Signalen, aufweist, über welchen eine Grundfrequenz (f₀) des Kammgenerators (K) vorgegeben werden kann.

11. Antenne mit Kammgenerator gemäß einem der vorangehenden Ansprüche,
**dadurch gekennzeichnet,**
- **dass** an den Synchronisationseingang ein Kabel (O) zur Führung von optischen Signalen zur Synchronisation des Kammgenerators (K) mit einem externen Signal an den Kammgenerator (K) angeschlossen ist.

12. Antenne mit Kammgenerator gemäß einem der Ansprüche 10 oder 11, **dadurch gekennzeichnet, dass** das optische Kabel (O) durch eine Öffnung im Hohlkegel (C1, C2) oder an der Grundfläche aus dem den Kammgenerator (K) umschließenden Hohlkegel (C1, C2) herausgeführt ist.

13. Anordnung mit einer Antenne (A) mit Kammgenerator (K) gemäß einem der Ansprüche 11 oder 12, sowie mit einer Empfangsantenne (E) und einem dieser Empfangsantenne (E) nachgeschalteten Messempfänger (M), wobei der Messempfänger (M) und der Kammgenerator (K) im Nahbereich der Antenne (A) mittels des optischen Kabels (O) verbunden sind, **dadurch gekennzeichnet,**
- **dass** die Empfangsantenne (E) mit der Antenne (A) bzw. den Kammgenerator (K), insbesondere mittels des Messempfängers (M), synchronisiert ist, und
- **dass** eine Synchronisationsfrequenz (fs) als Grundfrequenz (f₀) oder als vorgegebenes Vielfaches dieser Grundfrequenz gewählt wird, und
- **dass** der Empfangsantenne (E) ein Bandpassfilter (BP) nachgeschaltet ist, welcher auf ein Vielfaches (n) der vorgegebenen Synchronisationsfrequenz (f₀) eingestellt ist und für Signalanteile mit Frequenzen dieser Synchronisationsfrequenz (n * f₀) durchlässig ist.

14. Anordnung nach Anspruch 13 wobei die Anordnung für die Verwendung in einem quaderförmigen Raum angepasst ist, wobei
- die Wände des Raums und dessen Decke absorbierend wirken,
- der Boden des Raumes metallische oder absorbierende Eigenschaften aufweist,
- die Antenne (A) einer vorgegebenen Stelle des Raumes angeordnet ist, und
- die Empfangsantenne (E) an einer vorgegebenen Stelle des Raumes, insbesondere in vorgegebenem Abstand von der Antenne (A) und/oder in einer vorgegebenen Höhe, angeordnet ist.

15. Anordnung nach einem der Ansprüche 13 oder 14, **dadurch gekennzeichnet, dass** gegebenenfalls zur Erhöhung der Messdynamik die Messbandbreite des Bandpassfilters (BP) an die Bandbreite des durch die Grundfrequenz bestimmten Signals, typischerweise mit einer Abweichung mit weniger als 1 Hz bis zu 10 Hz, angepasst ist.

## Claims

1. Antenna with an interconnected comb generator for emitting low-distortion electromagnetic measuring fields in the MHz range up to the GHz range, the antenna (A) comprising two hollow cones (C1, C2), having an axis of symmetry (X) in common and a vertex (P) in common, the openings of which being oriented in opposite directions, wherein said two hollow cones (C1, C2) are, in particular, formed using metal or a wire grating, **characterised in**
- **that** said comb generator (K) is arranged in the inner space of one of the two hollow cones (C1, C2) which form said antenna (A), and
- **that** batteries (B) for current supply of said comb generator (K) are arranged in the inner space of that hollow cone (C1, C2) which houses said comb generator (K).

2. Antenna with comb generator according to claim 1, **characterised in**
- **that** the walls of said hollow cones (C1, C2) are formed of metal.

3. Antenna with comb generator according to claim 1, **characterised in**
- **that** the walls of said hollow cones (C1, C2) are formed from a wire mesh or a wire grating, and that said comb generator (K) as well as cables, which optionally go out from said comb generator, are provided with additional shielding measures.

4. Antenna with comb generator according to any of the preceding claims,
**characterised in**
- **that** said comb generator (K) is arranged on a, preferably flat, board.

5. Antenna with comb generator according to claim 4, **characterised in**
- **that** said batteries (B) are in a near range to said vertex (P) in the interior of that hollow cone (C1, C2) which encloses said comb generator (K), and
- **that** said board, on which said comb generator (K) is situated, is arranged on that side of the batteries (B) which is remote from said vertex (P).

6. Antenna with comb generator according to any of the preceding claims,
**characterised in**
- **that** each hollow cone (C1, C2) is prolonged at that end, which is remote from said vertex (P), by a wire grating (D) conically formed by one or more spines (G).

7. Antenna with comb generator according to claim 6, **characterised in**
- **that** to that ends of the individual wire grating spines (G) of a hollow cone (C1, C2), which are remote from said vertex (P), a further conically shaped wire grating is each connected and tapers to a further vertex (P1, P2).

8. Antenna with comb generator according to claim 7, **characterised in that** said vertices (P1, P2) are situated on said axis of symmetry (X), in particular at the same distance from said vertex (P).

9. Antenna with comb generator according to claim 7 or 8, **characterised in that** said two vertices (P1, P2) and the ends of said wire gratings (D) have the same distance to the vertex (P) which is in common.

10. Antenna with comb generator according to any of the preceding claims,
**characterised in**
- **that** said comb generator (K) comprises a synchronisation inlet, particularly an or connection for a cable for guiding optical signals, over which a basic frequency (f₀) of the comb generator (K) can be predetermined.

11. Antenna with comb generator according to any of the preceding claims,
**characterised in**
- a cable (O) is connected to the synchronisation inlet and to said comb generator (K) for guiding optical signals for synchronising said comb generator (K) with an external signal.

12. Antenna with comb generator according to any of claims 10 or 11, **characterised in that** said optical cable (O) is lead out through an opening in said hollow cone (C1, C2) or at the base surface from that hollow cone (C1, C2) which encloses said comb generator (K).

13. An arrangement comprising an antenna (A) with comb generator (K) according to any of claims 11 or 12 as well as a receiving antenna (E) and a measuring receiver (M) in series after said receiving antenna (E), said measuring receiver (M) and said comb generator (K) are interconnected in the antenna-proximity zone by means of the optical cable (O), **characterised in,**
- **that** said receiving antenna (E) is synchronised with said antenna (A) or the comb generator (K), particularly by means of said measuring receiver (M), and
- **that** a synchronisation frequency (fs) is chosen as a basic frequency (f₀) or as a predetermined multiple of this basic frequency, and
- **that** a band-pass filter (BP) is in series after said receiving antenna (E), and is adjusted to a multiple (n) of said predetermined synchronisation frequency (f₀), and is permeable for signal portions having the frequency of said synchronisation frequency (n*f₀).

14. Arrangement according to claim 13, the arrangement being adapted for use in a parallelepiped room, wherein
- the walls of said room and its ceiling have an absorbing effect,
- the floor of said room has metallic or absorbing properties,
- said antenna (A) is situated at a predetermined site of said room, and
- said receiving antenna (E) is situated at a predetermined site of said room, particularly at a predetermined distance from said antenna (A) and/or in a predetermined height.

15. Arrangement according to any of claims 13 or 14, **characterised in that,** optionally for intensifying the measuring dynamics, the measuring band width of the band-pass filter (BP) is adapted to the band width of that signal, which is determined by the basic frequency, typically with a variation of less than 1 Hz up to 10 Hz.

## Revendications

1. Antenne dotée d'un générateur de peigne pour émettre des champs de mesure électromagnétiques à peu distorsions dans la plage de MHz jusqu'à GHz, l'antenne (A) comprenant deux cônes creux (C1, C2) à une axe de symétrie (X) en commun et un sommet (P) en commun, dont les ouvertures sont dirigées en directions opposées, dans laquelle les deux cônes creux (C1, C2) sont formés, en particulier, en utilisant du métal ou un grille de fils de métal, **caractérisée en ce,**
- **que** le générateur de peigne (K) est disposé dans l'espace intérieur de l'un des deux cônes creux (C1, C2), qui forment l'antenne (A), et
- **que** des batteries (B) pour l'alimentation électrique du générateur de peigne (K) sont disposées dans l'espace intérieur de ce cône creux (C1, C2), qui contient le générateur de peigne (K).

2. Antenne dotée d'un générateur de peigne selon la revendication 1, **caractérisée en ce,**
- **que** les parois des cônes creux (C1, C2) sont formées de métal.

3. Antenne dotée d'un générateur de peigne selon la revendication 1, **caractérisée en ce,**
- **que** les parois des cônes creux (C1, C2) sont formées d'un treillis de fil métallique ou d'un grille en fils métallique, et que le générateur de peigne (K) ainsi que des câbles, le cas échéant émergeant du générateur de peigne (K), sont pourvus des mesures à écran additionnelles.

4. Antenne dotée d'un générateur de peigne selon une quelconque des revendications précédentes, **caractérisée en ce,**
- **que** le générateur de peigne () est disposé sur une platine, préférablement platte.

5. Antenne dotée d'un générateur de peigne selon la revendication 4, **caractérisée en ce,**
- **que** les batteries (B) sont disposées dans la zone immédiate du sommet (P) à l'intérieur de ce cône creux (C1, C2), qui enveloppe le générateur de peigne (K), et
- **que** la platine, à laquelle le générateur de peine (K) est disposé, est disposée au côté éloigné du sommet (P) des batteries (B).

6. Antenne dotée d'un générateur de peigne selon une quelconque des revendications précédentes, **caractérisée en ce**,
- chaque cône creux (C1, C2) est prolongé à son bout éloigné du sommet (P) par une grille en fils métalliques (D) conique, formée avec plusieurs barreaux (G).

7. Antenne dotée d'un générateur de peigne selon la revendication 6, **caractérisée en ce,**
- **qu**'aux bouts des barreaux de grille en fils métalliques, qui sont éloignés du sommet (P), une autre grille en fils métalliques conique est reliée, qui converge vers un autre sommet (P1, P2).

8. Antenne dotée d'un générateur de peigne selon la revendication 7, **caractérisée en ce, que** les sommets (P1, P2) sont situés à l'axe de symétrie (X), particulièrement à la même distance du sommet (P).

9. Antenne dotée d'un générateur de peigne selon la revendication 7 ou 8, **caractérisée en ce, que** les deux sommets (P1, P2) et les bouts des grilles en fils métalliques (D) ont la même distance du sommet (P) en commun.

10. Antenne dotée d'un générateur de peigne selon une quelconque des revendications précédentes, **caractérisée en ce,**
- **que** le générateur de peigne (K) comprend une entrée de synchronisation, particulièrement un ou raccord pour un câble pour conduire des signaux optiques, au moyen duquel on peut prédéterminer une fréquence de base (f₀) du générateur de peigne (K).

11. Antenne dotée d'un générateur de peigne selon une quelconque des revendications précédentes, **caractérisée en ce,**
- **qu**'un câble (O) avec un signal externe est relié à l'entrée de synchronisation pour conduire des signaux optiques pour la synchronisation du générateur de peigne (K) au générateur de peine (K).

12. Antenne dotée d'un générateur de peigne selon la revendication 10 ou 11, **caractérisée en ce, que** le câble optique (O) émerge du cône creux (C1, C2), qui enveloppe le générateur de peigne (K) à travers d'une ouverture dans le cône creux (C1, C2) ou à la surface de base.

13. Disposition avec une antenne (A) dotée d'un générateur de peigne (K) selon une quelconque des revendications 11 ou 12, ainsi qu'avec une antenne de réception (E) et un récepteur de mesure (M) mis en série après cette antenne de réception (E), le récepteur de mesure (M) et le générateur de peigne (K) étant reliés dans la zone immédiate de l'antenne (A) au moyen du câble optique (O), **caractérisée en ce,**
- **que** l'antenne de réception (E) est synchronisée avec l'antenne (A) ou le générateur de peigne (K), particulièrement au moyen du récepteur de mesure (M), et
- **que** l'on choisi une fréquence de synchronisation (fs) comme fréquence de base (f₀) ou comme un multiple prédéterminé de cette fréquence de base, et
- **qu'**un passe-bande (BP) est mis en série après l'antenne de réception (E), qui est ajusté à un multiple (n) de la fréquence de synchronisation (f₀) prédéterminée, et est perméable pour les portions de signaux ayant la fréquence de cette fréquence de synchronisation (n*f₀).

14. Disposition selon la revendication 13, dans laquelle la disposition est adaptée à l'utilisation dans un espace parallélépipédique, où
- les parois de l'espace et le plafond de ceci ont un effet absorbant,
- le sol de l'espace a des propriétés métalliques ou absorbantes,
- l'antenne (A) est disposée à une place prédéterminée, et
- l'antenne de réception (E) est disposé à une place prédéterminée de l'espace, particulièrement à une distance prédéterminé de l'antenne (A) et/ou à une hauteur prédéterminée.

15. Disposition selon une quelconque des revendications 13 ou 14, **caractérisée en ce, que,** le cas échéant pour augmenter la dynamique de mesurage, la largeur de bande de mesurage du passe-bande (BP) est adaptée à la largeur de bande du signal déterminé par la fréquence de base, typiquement avec une tolérance de moins de 1 Hz jusqu'à 10 Hz.
